# EUROPÄISCHE PATENTANMELDUNG

(11) **EP 2 645 401 A2**
(43) Veröffentlichungstag der Anmeldung: **02.10.2013**
(21) Anmeldenummer: 13161861.3
(22) Anmeldetag: 29.03.2013
(51) Int. Cl.: H01J 37/20

(54) **Verfahren zur Einstellung einer Position eines Trägerelements in einem Teilchenstrahlgerät**

(30) Priorität: 30.03.2012 DE 102012205317
(71) Anmelder: Carl Zeiss Microscopy GmbH, 07745 Jena (DE)
(72) Erfinder: Knappich, Matthias, 73432 Aalen (DE)
(74) Vertreter: Tongbhoyai, Martin

(57) **Zusammenfassung**

Die Erfindung betrifft ein Verfahren zur Einstellung einer Position eines Trägerelements, das in einem Teilchenstrahlgerät angeordnet ist, wobei das Trägerelement zur Aufnahme eines Objekts ausgebildet ist, wobei das Teilchenstrahlgerät mindestens einen Strahlerzeuger zur Erzeugung eines Teilchenstrahls und mindestens ein Objektiv zur Fokussierung des Teilchenstrahls aufweist, und wobei das Trägerelement mittels mindestens eines ersten Schrittmotors beweglich ausgebildet ist. Das Verfahren weist die folgenden Schritte auf: Starten einer Bewegung des Trägerelements durch Ansteuern des ersten Schrittmotors mit einem als Wechselstrom ausgebildeten ersten Motorstrom; Einstellen des ersten Motorstroms auf eine erste Frequenz und auf eine erste Amplitude, und Abbremsen der Bewegung des Trägerelements durch Verringern der ersten Frequenz und durch Verringern der ersten Amplitude des ersten Motorstroms, wobei die erste Frequenz in einem ersten vorgebbaren Zeitraum auf Null verringert wird und wobei die erste Amplitude im ersten vorgebbaren Zeitraum auf eine Amplitude eines vorgebbaren ersten Haltestroms verringert wird.

## Beschreibung

Die Erfindung betrifft ein Verfahren zur Einstellung einer Position eines Trägerelements, das in einem Teilchenstrahlgerät angeordnet ist. Das Trägerelement kann dabei beispielsweise als ein beweglich angeordneter Probentisch ausgebildet sein, auf dem eine zu untersuchende und/oder zu bearbeitende Probe (Objekt) angeordnet ist.

Aus dem Stand der Technik ist ein Teilchenstrahlgerät bekannt, beispielsweise ein Rasterelektronenmikroskop oder ein Ionenstrahlgerät, das mit einem Probentisch versehen ist, auf dem ein zu untersuchendes und/oder zu bearbeitendes Objekt angeordnet ist. Der Probentisch ist beweglich ausgebildet, wobei die bewegliche Ausbildung des Probentisches durch mehrere Bewegungselemente gewährleistet wird, aus denen der Probentisch zusammengesetzt ist. Die Bewegungselemente ermöglichen eine Bewegung des Probentisches in mindestens eine bestimmte Richtung. Insbesondere sind Probentische bekannt, die mehrere translatorische Bewegungselemente (beispielsweise etwa 3-4 translatorische Bewegungselemente) sowie mehrere rotatorische Bewegungselemente (beispielsweise 2-3 rotatorische Bewegungselemente) aufweisen. Beispielsweise ist ein Probentisch entlang einer ersten Translationsachse (beispielsweise eine x-Achse), entlang einer zweiten Translationsachse (beispielsweise eine y-Achse) sowie entlang einer dritten Translationsachse (beispielsweise eine z-Achse) beweglich angeordnet. Die erste Translationsachse, die zweite Translationsachse und die dritte Translationsachse sind senkrecht zueinander orientiert. Ferner ist der Probentisch um eine erste Rotationsachse und um eine zu der ersten Rotationsachse senkrechte zweite Rotationsachse drehbar ausgebildet.

Die Antriebskraft für eine Bewegung mittels der Bewegungselemente wird beim Stand der Technik durch Schrittmotoren zur Verfügung gestellt. Jeweils ein Schrittmotor ist für jeweils eine Bewegung entlang einer der Translationsachsen oder für eine Drehung um eine der Rotationsachsen vorgesehen. Die Schrittmotoren können dabei in einer Vakuumkammer eines Teilchenstrahlgeräts oder auch außerhalb der Vakuumkammer des Teilchenstrahlgeräts angeordnet sein. Im letzteren Fall sind entsprechende Vakuumdurchführungen und mechanische Einrichtungen vorgesehen, um die Ansteuerung zwischen den Schrittmotoren und dem Probentisch zu gewährleisten.

Ein im Stand der Technik bekannter Schrittmotor weist den folgenden prinzipiellen Aufbau auf. Der Schrittmotor ist mit einem Rotor versehen, der drehbar im Schrittmotor angeordnet ist. Ferner weist der Schrittmotor Spulen auf, die um den Rotor angeordnet sind. Die Spulen stellen ein gesteuertes, schrittweise rotierendes elektromagnetisches Feld zur Verfügung, mit welchem der Rotor um einen minimalen Winkel oder um ein Vielfaches dieses minimalen Winkels gedreht werden kann. Auf diese Weise ist es möglich, eine gewisse Anzahl an Schritten pro Umdrehung des Rotors zu erzielen. Aus dem Stand der Technik sind Schrittmotoren mit unterschiedlichen Schrittzahlen pro Umdrehung des Rotors bekannt, beispielsweise mit 100 Schritten pro Umdrehung. Bei einem Schrittmotor mit 100 Schritten pro Umdrehung dreht der Rotor bei einem Vollschritt sich um jeweils 3,6 Grad.

Bei bekannten Schrittmotoren ist neben einem Betrieb, in dem der Schrittmotor Vollschritte durchführt, auch ein sogenannter Mikroschrittbetrieb möglich. Im Mikroschrittbetrieb werden kleinere Schritte als ein Vollschritt bereitgestellt. Hierzu wird der Schrittwinkel verkleinert. Dies wird durch eine Ansteuerung des Motorstroms für die bei dem Schrittmotor verwendeten Spulen bereitgestellt. Durch Anschalten oder Ausschalten des Motorstroms an den einzelnen Spulen des Schrittmotors wird ein stufenförmiger Gesamtsteuerstromverlauf erzielt, welcher durch die Verhältnisse der Amplitude des an den einzelnen Spulen angelegten Motorstroms gegeben ist. Die Ansteuerung des Schrittmotors erfolgt somit durch eine wählbare Ansteuerung des Motorstroms für die einzelnen, bei dem Schrittmotor verwendeten Spulen. Durch eine wählbare phasenverschobene Ansteuerung des Motorstroms für die einzelnen Spulen des Schrittmotors können Vollschritte oder kleinere Schritte (beispielsweise Halbschritte, Achtelschritte oder kleinere Schritte) erzielt werden. Die Amplitude eines ersten Motorstroms, der an eine erste Spule eines Schrittmotors angelegt wird, und die Amplitude eines zweiten Motorstroms, der an eine zweite Spule des Schrittmotors angelegt wird, sind nicht abhängig von der Schrittweite (also beispielsweise einem Vollschritt, einem Halbschritt oder einem anderen Schritt) und sind daher bei jeder gewählten Schrittweite stets gleich.

Bei einem Teilchenstrahlgerät ist es wünschenswert, dass die Positionseinstellung des Probentisches möglichst genau ist. Dies ist insbesondere für ein gutes Auflösungsvermögen oder eine genaue Abbildung eines auf dem Probentisch angeordneten Objekts (Probe) wünschenswert. Wird nun bei einem Schrittmotor der Mikroschrittbetrieb verwendet, kann es zu Problemen bei der Positionseinstellung des Probentisches kommen, wenn der Schrittmotor angehalten wird. Zum Anhalten wird der Rotor des Schrittmotors abgebremst. Das bedeutet, dass beim Abbremsen des Probentisches (und demnach auch beim Anhalten des Probentisches) die Frequenz des Motorstroms zur Ansteuerung der einzelnen Spulen auf Null heruntergefahren wird. Die Frequenz des Motorstroms für den Schrittmotor ist ein Maß für die Geschwindigkeit des Schrittmotors, und somit auch ein Maß für die Geschwindigkeit des Probentisches. Beim Anhalten des Schrittmotors bleibt der Rotor in einer vorgebbaren Position, welche durch einen der Mikroschritte vorgegeben ist, stehen. Der Motorstrom nimmt in dieser Position einen Wert ein, der durch eine Betriebsamplitude und eine Betriebsphase des in dieser Motorstellung notwendigen Motorstroms für den Schrittmotor vorgegeben ist. Diese Betriebsamplitude ist statisch. Sie kann zu einer übermäßigen thermischen Belastung des Schrittmotors führen, was nicht erwünscht ist. Aus diesem Grund ist es bei dem Stand der Technik vorgesehen, dass nach dem Anhalten die Amplitude des Motorstroms auf eine vorgebbare Halteamplitude abgesenkt wird. Der Motorstrom, der diese Halteamplitude aufweist, wird auch als Haltestrom bezeichnet. Bei dem Haltestrom ist die Erwärmung der Bauteile auf einem vertretbaren Maß.

Hinsichtlich des Standes der Technik wird auf die DE 10 2009 028 600 A1 sowie die DE 10 2010 020 550 A1 verwiesen.

Aufgrund der bestehenden elektromagnetischen Felder kommt es jedoch beim Absenken des Motorstroms auf die vorgebbare Halteamplitude dazu, dass sich der Rotor des Schrittmotors in Richtung des nächsten Vollschrittes ein wenig bewegt. Hierdurch wird auch der Probentisch bewegt. Dies führt demnach zu einer zusätzlichen nicht gewünschten Bewegung und zu einer nicht gewünschten Position des Probentisches. Das auf dem Probentisch angeordnete Objekt wird gegebenenfalls falsch positioniert.

Demnach ist es wünschenswert, wenn zum einen die Position des Probentisches genau und ohne ungewünschte Zusatzbewegung angesteuert werden kann und zum anderen die Position des Probentisches stets mit einer hohen Genauigkeit bekannt ist. Der Erfindung liegt die Aufgabe zu Grunde, ein Verfahren anzugeben, mit dem dieses erzielbar ist.

Diese Aufgabe wird mit einem Verfahren zur Einstellung einer Position eines Trägerelements mit den Merkmalen des Anspruchs 1 gelöst. Ein Computerprogrammprodukt, das einen Programmcode aufweist, der zur Ausführung eines entsprechenden Verfahrens geeignet ist, ist durch die Merkmale des Anspruchs 19 gegeben. Die Erfindung betrifft nach Anspruch 20 oder 21 auch ein Teilchenstrahlgerät, das ein entsprechendes Verfahren ausführt und/oder einen Steuerungsprozessor aufweist, in den ein Computerprogrammprodukt ladbar ist, das ein entsprechendes Verfahren ausführt.

Das erfindungsgemäße Verfahren nach Anspruch 1 ist zur Einstellung einer Position eines Trägerelements vorgesehen, das in einem Teilchenstrahlgerät angeordnet ist. Das Trägerelement wird auch als Probentisch oder auch als Objekttisch bezeichnet. Das Trägerelement ist zur Aufnahme eines Objekts ausgebildet, das untersucht und/oder bearbeitet werden soll. Das Teilchenstrahlgerät weist mindestens einen Strahlerzeuger zur Erzeugung eines Teilchenstrahls und mindestens ein Objektiv zur Fokussierung des Teilchenstrahls auf. Mittels des Teilchenstrahls wird das Objekt beispielsweise untersucht und/oder bearbeitet.

Das Trägerelement ist mittels mindestens eines ersten Schrittmotors beweglich ausgebildet. Das Verfahren gemäß der Erfindung weist die folgenden Schritte auf:
- Starten einer Bewegung des Trägerelements durch Ansteuern des ersten Schrittmotors mittels eines als Wechselstrom ausgebildeten ersten Motorstroms,
- Einstellen des ersten Motorstroms auf eine erste Frequenz und auf eine erste Amplitude, und
- Abbremsen der Bewegung des Trägerelements durch Verringern der ersten Frequenz und Verringern der ersten Amplitude des ersten Motorstroms, wobei die erste Frequenz in einem ersten vorgebbaren Zeitraum auf Null verringert wird, und wobei die erste Amplitude im ersten vorgebbaren Zeitraum auf eine Amplitude eines vorgebbaren ersten Haltestroms verringert wird.

Die Erfindung geht von der folgenden überraschenden Erkenntnis aus. Insbesondere im Mikroschrittbetrieb des ersten Schrittmotors wird während eines Abbremsvorgangs des ersten Schrittmotors, bei dem die erste Frequenz des ersten Motorstroms während des Abbremszeitraums verringert und auf Null eingestellt wird, auch die erste Amplitude des ersten Motorstroms verändert. Die erste Amplitude wird beim Abbremsvorgang derart abgesenkt, bis der Haltestrom erreicht ist. Bei diesem Haltestrom ist der erste Schrittmotor im Stillstand. Die Ansteuerung des ersten Motorstroms zum Erzielen einer Halteposition (das heißt die Reduzierung der Amplitude des Motorstroms auf den Haltestrom) erfolgt also, noch während der erste Schrittmotor in Bewegung ist. Die Erfindung ermöglicht zum einen, dass der erste Schrittmotor (und damit auch das Trägerelement) an einer gewünschten Position stehen bleibt und kein Bewegen des ersten Schrittmotors in Richtung des nächsten Vollschrittes mehr erfolgt. Ferner ermöglicht die Erfindung zum anderen, dass es zu keinen hohen Erwärmungen des ersten Schrittmotors kommt. Die Verringerung der ersten Frequenz und/oder der ersten Amplitude kann im ersten vorgebbaren Zeitraum sprunghaft erfolgen (also zu einem bestimmten Zeitpunkt im ersten vorgebbaren Zeitraum) oder über den ersten vorgebbaren Zeitraum stetig erfolgen. Der erste Motorstrom wird beispielsweise Spulen, welche im ersten Schrittmotor enthalten sind, phasenversetzt zugeführt.

Es wird explizit darauf hingewiesen, dass die Abfolge der vorstehend und nachstehend erläuterten Verfahrensschritte beliebig ist. Es ist jede geeignete Abfolge der Verfahrensschritte verwendbar.

Bei einer Ausführungsform des erfindungsgemäßen Verfahrens ist es zusätzlich oder alternativ vorgesehen, dass das Starten der Bewegung des Trägerelements eine Beschleunigung während eines zweiten vorgebbaren Zeitraums umfasst. Der erste Motorstrom wird mit einer ersten Beschleunigungs-Frequenz und mit einer ersten Beschleunigungs-Amplitude während des zweiten vorgebbaren Zeitraums angesteuert, wobei die erste Beschleunigungs-Frequenz und die erste Beschleunigungs-Amplitude während des zweiten vorgebbaren Zeitraums beispielsweise durch Erhöhung geändert werden, bis die erste Frequenz und die erste Amplitude eingestellt sind. Dabei ist es vorgesehen, dass die erste Frequenz größer als die erste Beschleunigungs-Frequenz ist und dass die erste Amplitude größer als die erste Beschleunigungs-Amplitude ist. Bei einem Ausführungsbeispiel ist es vorgesehen, dass die Änderung der ersten Beschleunigungs-Amplitude während des zweiten vorgebbaren Zeitraums stetig oder sprunghaft erfolgt.

Bei einem weiteren Ausführungsbeispiel des erfindungsgemäßen Verfahrens ist es alternativ oder zusätzlich vorgesehen, dass die erste Frequenz und/oder die erste Amplitude während eines dritten vorgebbaren Zeitraums konstant gehalten werden.

Bei einem wiederum weiteren Ausführungsbeispiel des erfindungsgemäßen Verfahrens ist es zusätzlich oder alternativ vorgesehen, dass das Trägerelement entlang mindestens einer Translationsachse bewegt wird. Beispielsweise ist es vorgesehen, dass das Trägerelement entlang mindestens einer ersten Translationsachse und entlang mindestens einer zweiten Translationsachse bewegt wird. Bei diesem Ausführungsbeispiel sind Bewegungen in einer Ebene vorgesehen, die durch die erste Translationsachse und die zweite Translationsachse aufgespannt wird. Beispielsweise ist es zusätzlich oder alternativ vorgesehen, dass die erste Translationsachse und die zweite Translationsachse senkrecht zueinander orientiert sind. Bei einem weiteren Ausführungsbeispiel ist es vorgesehen, dass das Trägerelement entlang einer dritten Translationsachse bewegt wird. Beispielsweise ist es vorgesehen, dass das Trägerelement entlang der ersten Translationsachse, entlang der zweiten Translationsachse und/oder entlang der dritten Translationsachse bewegt wird. Insbesondere ist es vorgesehen, dass die erste Translationsachse, die zweite Translationsachse und/oder die dritte Translationsachse senkrecht zueinander orientiert sind.

Bei einem wiederum weiteren Ausführungsbeispiel des erfindungsgemäßen Verfahrens ist es zusätzlich oder alternativ vorgesehen, dass das Trägerelement um mindestens eine erste Rotationsachse und/oder um mindestens eine zweite Rotationsachse gedreht wird. Beispielsweise ist es vorgesehen, dass die erste Rotationsachse und die zweite Rotationsachse senkrecht zueinander orientiert sind.

Es wird explizit darauf hingewiesen, dass die Anzahl der Translationsachsen und die Anzahl der Rotationsachsen nicht auf die vorgenannte Anzahl eingeschränkt sind. Vielmehr ist jede Anzahl von Translationsachsen und jede Anzahl von Rotationsachsen für das erfindungsgemäße Verfahren verwendbar.

Bei einem wiederum weiteren Ausführungsbeispiel des erfindungsgemäßen Verfahrens ist es zusätzlich oder alternativ vorgesehen, mehrere Schrittmotoren für das Trägerelement zu verwenden. So ist es beispielsweise vorgesehen, dass das Trägerelement entlang der ersten Translationsachse mittels des ersten Schrittmotors bewegt wird. Ferner ist es beispielsweise vorgesehen, dass das Trägerelement entlang der zweiten Translationsachse mittels eines zweiten Schrittmotors bewegt wird. Zusätzlich oder alternativ ist es vorgesehen, dass das Trägerelement entlang der dritten Translationsachse mittels eines dritten Schrittmotors bewegt wird.

Die Ansteuerung des zweiten Schrittmotors und/oder des dritten Schrittmotors erfolgt bei einem Ausführungsbeispiel des erfindungsgemäßen Verfahrens wie bei dem ersten Schrittmotor. So ist es zusätzlich oder alternativ vorgesehen, dass ein Starten einer Bewegung des Trägerelements durch Ansteuern des zweiten Schrittmotors mit einem als Wechselstrom ausgebildeten zweiten Motorstrom erfolgt. Ferner erfolgt ein Einstellen des zweiten Motorstroms auf eine zweite Frequenz und auf eine zweite Amplitude. Darüber hinaus ist auch ein Abbremsen der Bewegung des Trägerelements durch Verringern der zweiten Frequenz und durch Verringern der zweiten Amplitude des zweiten Motorstroms vorgesehen. Dabei wird die zweite Frequenz in einem vierten vorgebbaren Zeitraum auf Null verringert, und die zweite Amplitude wird im vierten vorgebbaren Zeitraum auf eine Amplitude eines vorgebbaren zweiten Haltestroms verringert. Auch hier ist es vorgesehen, dass die Verringerung der zweiten Frequenz und/oder der zweiten Amplitude im vierten vorgebbaren Zeitraum sprunghaft erfolgen kann (also zu einem bestimmten Zeitpunkt im vierten vorgebbaren Zeitraum). Alternativ hierzu ist es vorgesehen, dass über den vierten vorgebbaren Zeitraum die Verringerung der zweiten Frequenz und/oder der zweiten Amplitude stetig erfolgt. Der zweite Motorstrom wird beispielsweise Spulen, welche im zweiten Schrittmotor enthalten sind, phasenversetzt zugeführt.

Bei einer weiteren Ausführungsform des erfindungsgemäßen Verfahrens ist es nun zusätzlich oder alternativ vorgesehen, dass ein Starten einer Bewegung des Trägerelements durch Ansteuern des dritten Schrittmotors mit einem als Wechselstrom ausgebildeten dritten Motorstrom erfolgt. Es erfolgt dann eine Einstellung des dritten Motorstroms auf eine dritte Frequenz und auf eine dritte Amplitude. Ferner erfolgt ein Abbremsen der Bewegung des Trägerelements durch Verringern der dritten Frequenz und durch Verringern der dritten Amplitude des dritten Motorstroms, wobei die dritte Frequenz in einem fünften vorgebbaren Zeitraum auf Null verringert wird und wobei die dritte Amplitude im fünften vorgebbaren Zeitraum auf eine Amplitude eines vorgebbaren dritten Haltestroms geändert wird. Die Verringerung der dritten Frequenz und/oder der dritten Amplitude kann im fünften vorgebbaren Zeitraum sprunghaft erfolgen (also zu einem bestimmten Zeitpunkt im fünften vorgebbaren Zeitraum). Alternativ hierzu ist es vorgesehen, dass über den fünften vorgebbaren Zeitraum die Verringerung der dritten Frequenz und/oder der dritten Amplitude stetig erfolgt. Der dritte Motorstrom wird beispielsweise Spulen, welche im dritten Schrittmotor enthalten sind, phasenversetzt zugeführt.

Bei einem wiederum weiteren Ausführungsbeispiel des erfindungsgemäßen Verfahrens ist es zusätzlich oder alternativ vorgesehen, den Zeitraum des Startens einer Bewegung des zweiten Schrittmotors besonders auszugestalten. So umfasst bei diesem Ausführungsbeispiel das Starten der Bewegung des Trägerelements ein Beschleunigen während eines sechsten vorgebbaren Zeitraums. Der zweite Motorstrom wird mit einer zweiten Beschleunigungs-Frequenz und mit einer zweiten Beschleunigungs-Amplitude während des sechsten vorgebbaren Zeitraums angesteuert. Die zweite Beschleunigungs-Frequenz und die zweite Beschleunigungs-Amplitude werden während des sechsten vorgebbaren Zeitraums beispielsweise durch Erhöhung geändert, bis die zweite Frequenz und die zweite Amplitude eingestellt sind. Die zweite Frequenz ist größer als die zweite Beschleunigungs-Frequenz, und die zweite Amplitude ist größer als die zweite Beschleunigungs-Amplitude. Bei einem Ausführungsbeispiel ist es vorgesehen, dass die Änderung der zweiten Beschleunigungs-Amplitude während des sechsten vorgebbaren Zeitraums stetig oder sprunghaft erfolgt.

Bei einem wiederum weiteren Ausführungsbeispiel des erfindungsgemäßen Verfahrens ist es zusätzlich oder alternativ vorgesehen, auch die Startphase der Bewegung des dritten Schrittmotors besonders auszugestalten. So ist es beispielsweise vorgesehen, dass das Starten der Bewegung des Trägerelements eine Beschleunigung während eines siebten vorgebbaren Zeitraums umfasst. Der dritte Motorstrom wird mit einer dritten Beschleunigungs-Frequenz und mit einer dritten Beschleunigungs-Amplitude während des siebten vorgebbaren Zeitraums angesteuert. Die dritte Beschleunigungs-Frequenz und die dritte Beschleunigungs-Amplitude werden während des siebten vorgebbaren Zeitraums beispielsweise durch Erhöhung geändert, bis die dritte Frequenz und die dritte Amplitude eingestellt sind. Die dritte Frequenz ist größer als die dritte Beschleunigungs-Frequenz, und die dritte Amplitude ist größer als die dritte Beschleunigungs-Amplitude. Bei einem Ausführungsbeispiel ist es vorgesehen, dass die Änderung der dritten Beschleunigungs-Amplitude während des siebten vorgebbaren Zeitraums stetig oder sprunghaft erfolgt.

Bei einem wiederum weiteren Ausführungsbeispiel des erfindungsgemäßen Verfahrens ist es zusätzlich oder alternativ vorgesehen, dass die zweite Frequenz und/oder die zweite Amplitude über einen elften Zeitraum konstant gehalten werden. Beispielsweise ist es zusätzlich oder alternativ auch vorgesehen, dass die dritte Frequenz und/oder die dritte Amplitude über einen zwölften vorgebbaren Zeitraum konstant gehalten werden.

Bei einem wiederum weiteren Ausführungsbeispiel des erfindungsgemäßen Verfahrens ist es zusätzlich oder alternativ vorgesehen, dass das Trägerelement um die erste Rotationsachse mittels eines vierten Schrittmotors gedreht wird. Zusätzlich oder alternativ ist es bei dem erfindungsgemäßen Verfahren vorgesehen, dass das Trägerelement um die zweite Rotationsachse mittels eines fünften Schrittmotors gedreht wird.

Die Ansteuerung des vierten Schrittmotors und/oder des fünften Schrittmotors erfolgt beispielsweise analog zu der Ansteuerung mindestens eines der bereits weiter oben genannten Schrittmotoren. So ist es bei dem erfindungsgemäßen Verfahren zusätzlich oder alternativ vorgesehen, dass ein Starten einer Bewegung des Trägerelements durch Ansteuern des vierten Schrittmotors mit einem als Wechselstrom ausgebildeten vierten Motorstrom erfolgt. Es erfolgt dann ein Einstellen des vierten Motorstroms auf eine vierte Frequenz und auf eine vierte Amplitude. Darüber hinaus erfolgt ein Abbremsen der Bewegung des Trägerelements durch Verringern der vierten Frequenz und durch Verringern der vierten Amplitude. Die vierte Frequenz wird in einem achten vorgebbaren Zeitraum auf Null verringert. Ferner wird die vierte Amplitude im achten vorgebbaren Zeitraum auf eine Amplitude eines vorgebbaren vierten Haltestroms verringert. Die Verringerung der vierten Frequenz und/oder der vierten Amplitude kann im achten vorgebbaren Zeitraum sprunghaft erfolgen (also zu einem bestimmten Zeitpunkt im achten vorgebbaren Zeitraum). Alternativ hierzu ist es vorgesehen, dass über den achten vorgebbaren Zeitraum die Verringerung der vierten Frequenz und/oder der vierten Amplitude stetig erfolgt. Der vierte Motorstrom wird beispielsweise Spulen, welche im vierten Schrittmotor enthalten sind, phasenversetzt zugeführt.

Zusätzlich oder alternativ ist es vorgesehen, dass ein Starten einer Bewegung des Trägerelements durch Ansteuern des fünften Schrittmotors mit einem als Wechselstrom ausgebildeten fünften Motorstrom erfolgt. Ferner erfolgt zusätzlich oder alternativ ein Einstellen des fünften Motorstroms auf eine fünfte Frequenz und eine fünfte Amplitude. Darüber hinaus erfolgt ein Abbremsen der Bewegung des Trägerelements durch Verringern der fünften Frequenz und durch Verringern der fünften Amplitude des fünften Motorstroms, wobei die fünfte Frequenz in einem neunten vorgebbaren Zeitraum auf Null verringert wird und wobei die fünfte Amplitude im neunten vorgebbaren Zeitraum auf eine Amplitude eines vorgebbaren fünften Haltestroms verringert wird. Auch hier kann die Verringerung der fünften Frequenz und/oder der fünften Amplitude kann im neunten vorgebbaren Zeitraum sprunghaft erfolgen (also zu einem bestimmten Zeitpunkt im neunten vorgebbaren Zeitraum). Alternativ hierzu ist es vorgesehen, dass über den neunten vorgebbaren Zeitraum die Verringerung der fünften Frequenz und/oder der fünften Amplitude stetig erfolgt. Der fünfte Motorstrom wird beispielsweise Spulen, welche im fünften Schrittmotor enthalten sind, phasenversetzt zugeführt.

Bei einer Ausführungsform des erfindungsgemäßen Verfahrens ist es zusätzlich oder alternativ vorgesehen, dass die vierte Frequenz und/oder die vierte Amplitude über einen dreizehnten vorgebbaren Zeitraum konstant gehalten werden. Beispielsweise ist es zusätzlich oder alternativ vorgesehen, dass die fünfte Frequenz und/oder die fünfte Amplitude über einen vorgebbaren vierzehnten Zeitraum konstant gehalten werden.

Bei einer weiteren Ausführungsform des erfindungsgemäßen Verfahrens ist es zusätzlich oder alternativ vorgesehen, dass das Starten einer Bewegung des Trägerelements ein Beschleunigen während eines zehnten vorgebbaren Zeitraums umfasst. Der vierte Motorstrom wird mit einer vierten Beschleunigungs-Frequenz und mit einer vierten Beschleunigungs-Amplitude während des zehnten vorgebbaren Zeitraums angesteuert. Die vierte Beschleunigungs-Frequenz und die vierte Beschleunigungs-Amplitude werden während des zehnten vorgebbaren Zeitraums beispielsweise durch Erhöhung geändert, bis die vierte Frequenz und die vierte Amplitude eingestellt sind. Die vierte Frequenz ist größer als die vierte Beschleunigungs-Frequenz, und die vierte Amplitude ist größer als die vierte Beschleunigungs-Amplitude. Bei einem Ausführungsbeispiel ist es vorgesehen, dass die Änderung der vierten Beschleunigungs-Amplitude während des zehnten vorgebbaren Zeitraums stetig oder sprunghaft erfolgt.

Bei einem wiederum weiteren Ausführungsbeispiel des erfindungsgemäßen Verfahrens ist es zusätzlich oder alternativ vorgesehen, dass das Starten der Bewegung des Trägerelements ein Beschleunigen während eines fünfzehnten vorgebbaren Zeitraums umfasst. Der fünfte Motorstrom wird mit einer fünften Beschleunigungs-Frequenz und mit einer fünften Beschleunigungs-Amplitude während des fünfzehnten vorgebbaren Zeitraums angesteuert. Die fünfte Beschleunigungs-Frequenz und die fünfte Beschleunigungs-Amplitude werden während des fünfzehnten vorgebbaren Zeitraums beispielsweise durch Erhöhung geändert, bis die fünfte Frequenz und die fünfte Amplitude eingestellt sind. Die fünfte Frequenz ist größer als die fünfte Beschleunigungs-Frequenz. Ferner ist die fünfte Amplitude größer als die fünfte Beschleunigungs-Amplitude. Bei einem Ausführungsbeispiel ist es vorgesehen, dass die Änderung der fünften Beschleunigungs-Amplitude während des fünfzehnten vorgebbaren Zeitraums stetig oder sprunghaft erfolgt.

Es wird explizit darauf hingewiesen, dass mindestens zwei, beispielsweise alle der vorgenannten Schrittmotoren identisch ausgebildet sein können. Beispielsweise ist es zusätzlich oder alternativ vorgesehen, dass mindestens zwei der vorgenannten Schrittmotoren (beispielsweise alle der vorgenannten Schrittmotoren) mit demselben Motorstrom betrieben werden. Auch können beispielsweise mindestens zwei der vorgenannten Zeitdauern identisch sein.

Bei einem weiteren Ausführungsbeispiel des erfindungsgemäßen Verfahrens ist es zusätzlich oder alternativ vorgesehen, dass die Position des Trägerelements gemessen wird und die durch die Messung ermittelte Position des Trägerelements zur Ansteuerung von mindestens einem der vorgenannten Schrittmotoren verwendet wird. Hierzu ist es vorgesehen, dass das Teilchenstrahlgerät mindestens eine Messeinrichtung zur Messung der Position des Trägerelements und mindestens eine Steuereinheit zur Einstellung der Position des Trägerelements durch Ansteuerung von mindestens einem der vorgenannten Schrittmotoren aufweist. Dieses Ausführungsbeispiel ermöglicht beispielsweise eine geregelte Ansteuerung der Position des Trägerelements. Alternativ hierzu ist es vorgesehen, dass die Ansteuerung der Position des Trägerelements ungeregelt erfolgt.

Die Erfindung betrifft auch ein Computerprogrammprodukt, das einen Programmcode aufweist, der in einen Steuerungsprozessor eines Teilchenstrahlgeräts ladbar ist (oder geladen ist) und der bei einem Ablauf in dem Steuerungsprozessor das Teilchenstrahlgerät derart steuert, dass ein Verfahren mit mindestens einem der vorgenannten Verfahrensschritte oder einer Kombination von mindestens zwei der vorgenannten Verfahrensschritte durchgeführt werden kann.

Die Erfindung betrifft auch ein Teilchenstrahlgerät mit mindestens einem Strahlerzeuger zur Erzeugung eines Teilchenstrahls, mit mindestens einer Objektivlinse zur Fokussierung des Teilchenstrahls auf ein Objekt, mit mindestens einem Detektor zur Detektion von Wechselwirkungsteilchen und/oder Wechselwirkungsstrahlung, die bei Einfall des Teilchenstrahls auf das Objekt erzeugt werden, mit mindestens einem Trägerelement zur Anordnung des Objekts und mit mindestens einem Schrittmotor zur Bewegung des Trägerelements. Ferner weist das Teilchenstrahlgerät mindestens einen Steuerungsprozessor auf, der ein Computerprogrammprodukt mit mindestens einem der vorgenannten Merkmale aufweist. Beispielsweise weist das Teilchenstrahlgerät mindestens eine Messeinrichtung zur Messung der Position des Trägerelements und mindestes eine Steuereinheit zur Einstellung der Position des Trägerelements durch Ansteuerung mindestens eines der vorgenannten Schrittmotoren auf.

Ferner betrifft die Erfindung auch ein Teilchenstrahlgerät mit mindestens einem Strahlerzeuger zur Erzeugung eines Teilchenstrahls, mit mindestens einer Objektivlinse zur Fokussierung des Teilchenstrahls auf ein Objekt, mit mindestens einem Detektor zur Detektion von Wechselwirkungsteilchen und/oder Wechselwirkungsstrahlung, die bei Einfall des Teilchenstrahls auf das Objekt erzeugt werden, mit mindestens einem Trägerelement zur Anordnung des Objekts und mit mindestens einem Schrittmotor zur Bewegung des Trägerelements. Das Teilchenstrahlgerät, beispielsweise ein Steuerungsprozessor des Teilchenstrahlgeräts, ist derart konfiguriert, dass ein Starten einer Bewegung des Trägerelements durch Ansteuern des ersten Schrittmotors mit einem als Wechselstrom ausgebildeten ersten Motorstrom erfolgt, dass ein Einstellen des ersten Motorstroms auf eine erste Frequenz und auf eine erste Amplitude erfolgt, und dass ein Abbremsen der Bewegung des Trägerelements durch Verringern der ersten Frequenz und durch Verringern der ersten Amplitude des ersten Motorstroms erfolgt, wobei die erste Frequenz in einem ersten vorgebbaren Zeitraum auf Null verringert wird und wobei die erste Amplitude im ersten vorgebbaren Zeitraum auf eine Amplitude eines vorgebbaren ersten Haltestroms verringert wird. Ausführungsbeispiele dieses Teilchenstrahlgeräts sehen vor, dass das Teilchenstrahlgerät derart konfiguriert ist, dass ein Verfahren mit mindestens einem der vorgenannten Verfahrensschritte oder einer Kombination von mindestens zwei der vorgenannten Verfahrensschritte durchgeführt werden kann.

Nachfolgend wird die Erfindung anhand von Figuren mittels eines Ausführungsbeispiels näher beschrieben. Dabei zeigen
- Figur 1: eine schematische Darstellung eines Teilchenstrahlgeräts;
- Figur 2: eine schematische Darstellung eines Trägerelements in Form eines Probentisches;
- Figur 3: eine weitere schematische Darstellung des Trägerelements gemäß Figur 2;
- Figur 4: eine schematisches Darstellung eines Verlaufs einer Geschwindigkeit eines Schrittmotors;
- Figur 5: eine schematische Darstellung eines Motorstroms eines Schrittmotors; und
- Figur 6: eine weitere schematische Darstellung eines Motorstroms eines Schrittmotors.

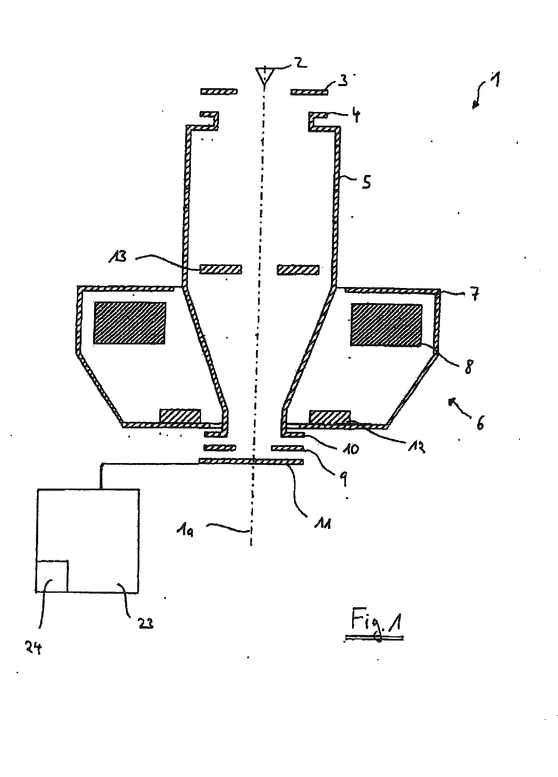

**Figur 1** zeigt eine schematische Darstellung einer Teilchenstrahlsäule 1 eines Teilchenstrahlgeräts, die als eine Elektronensäule ausgebildet ist und im Grunde genommen einer Elektronensäule eines Rasterelektronenmikroskops entspricht. Es wird aber bereits jetzt ausdrücklich darauf hingewiesen, dass die Erfindung nicht auf ein Rasterelektronenmikroskop eingeschränkt ist. Vielmehr ist die Erfindung bei jedem Teilchenstrahlgerät einsetzbar, insbesondere bei einem Ionenstrahlgerät.

Die Teilchenstrahlsäule 1 weist eine optische Achse 1a, einen Strahlerzeuger in Form einer Elektronenquelle 2 (Kathode), eine Extraktionselektrode 3 sowie eine Anode 4 auf, die gleichzeitig ein Ende eines Strahlführungsrohrs 5 bildet. Beispielsweise ist die Elektronenquelle 2 ein thermischer Feldemitter. Elektronen, die aus der Elektronenquelle 2 austreten, werden aufgrund einer Potentialdifferenz zwischen der Elektronenquelle 2 und der Anode 4 auf ein Anodenpotential beschleunigt. Es wird demnach ein Teilchenstrahl in Form eines Elektronenstrahls bereitgestellt.

Ferner weist die Teilchenstrahlsäule 1 eine Objektivlinse 6 auf. Die Objektivlinse 6 ist mit einer Bohrung versehen, durch welche das Strahlführungsrohr 5 geführt ist. Die Objektivlinse 6 weist ferner Polschuhe 7 auf, in denen Spulen 8 angeordnet sind.

Hinter das Strahlführungsrohr 5 ist eine elektrostatische Verzögerungseinrichtung geschaltet. Diese besteht aus einer Einzelelektrode 9 und einer Rohrelektrode 10. Die Rohrelektrode 10 liegt an dem zu einem Trägerelement 11 benachbarten Ende des Strahlführungsrohrs 5. Auf das Trägerelement 11 wird weiter unten noch näher eingegangen. Die Rohrelektrode 10 liegt gemeinsam mit dem Strahlführungsrohr 5 auf Anodenpotential. Hingegen liegen die Einzelelektrode 9 sowie eine auf dem Trägerelement 11 angeordnete Probe auf einem gegenüber dem Anodenpotential niedrigen Potential. Auf diese Weise können die Elektronen des Teilchenstrahls auf eine gewünschte Energie abgebremst werden, die für die Untersuchung einer auf dem Trägerelement 11 angeordneten Probe erforderlich ist. Die Teilchenstrahlsäule 1 weist zudem eine Rastereinrichtung 12 auf, durch welche der Teilchenstrahl abgelenkt und über eine auf dem Trägerelement 11 angeordnete Probe gerastert werden kann.

Zur Bildgebung werden mittels eines im Strahlführungsrohr 5 angeordneten Detektors 13 Sekundärelektronen und/oder Rückstreuelektronen detektiert, die aufgrund der Wechselwirkung des Teilchenstrahls mit einer auf dem Trägerelement 11 angeordneten Probe entstehen. Die von dem Detektor 13 erzeugten Signale werden zur Bildgebung an eine Elektronikeinheit (nicht dargestellt) übermittelt.

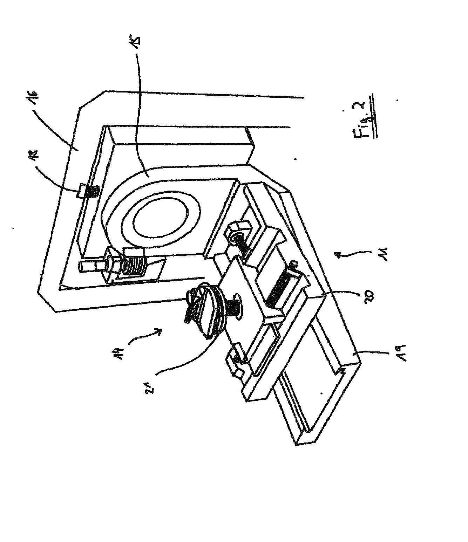

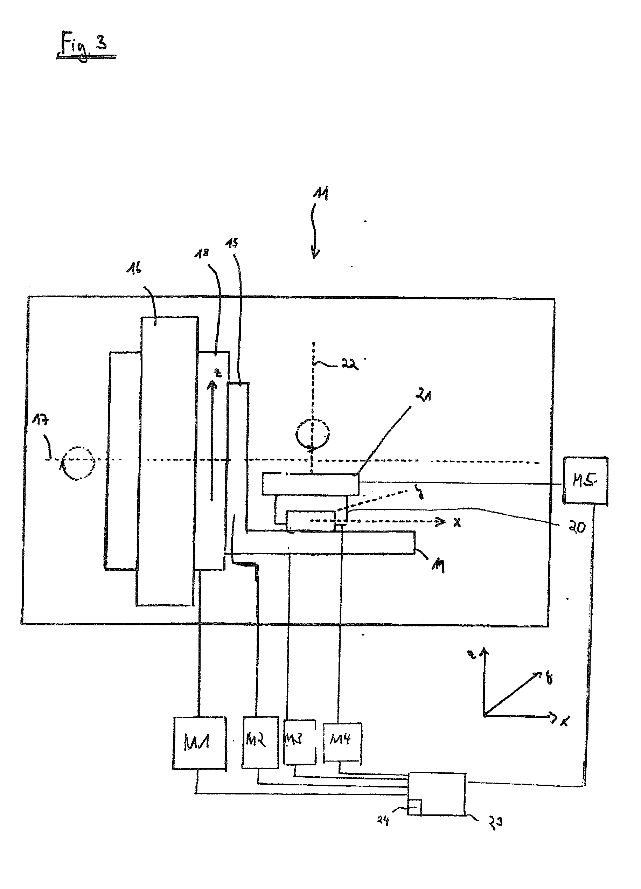

Nachfolgend wird nun auf das Trägerelement 11 näher eingegangen. Das Trägerelement 11 ist als beweglicher Probentisch ausgebildet, welcher in den **Figuren 2** **und** **3** schematisch dargestellt ist. Es wird bereits jetzt darauf hingewiesen, dass die Erfindung nicht auf das hier beschriebene Trägerelement 11 eingeschränkt ist. Vielmehr kann die Erfindung für jegliche Ausgestaltung eines beweglichen Trägerelements vorgesehen sein.

Das Trägerelement 11 weist eine Probenaufnahme 14 auf, an der eine Probe angeordnet wird. Das als Probentisch ausgebildete Trägerelement 11 weist Bewegungselemente auf, welche eine Bewegung des Trägerelements 11 derart sicherstellen, dass ein interessierender Bereich auf der Probe mittels eines Teilchenstrahls untersucht werden kann. Die Bewegungselemente sind in den **Figuren 2** **und** **3** schematisch dargestellt und werden nachfolgend erläutert.

Das Trägerelement 11 weist ein erstes Bewegungselement 18 an einem Gehäuse 16 einer Probenkammer auf, in welcher das Trägerelement 11 angeordnet ist und welche mit der Teilchenstrahlsäule 1 verbunden ist (nicht dargestellt). Mit dem ersten Bewegungselement 18 wird eine Bewegung des Trägerelements 11 entlang der z-Achse (erste Translationsachse) ermöglicht. Ferner ist ein zweites Bewegungselement 15 vorgesehen. Das zweite Bewegungselement 15 ermöglicht eine Drehung des Trägerelements 11 um eine erste Drehachse 17, welche auch als Tilt-Achse bezeichnet wird (erste Rotationsachse). Dieses zweite Bewegungselement 15 dient einer Kippung einer in der Probenaufnahme 14 angeordneten Probe um die erste Drehachse 17.

An dem zweiten Bewegungselement 15 ist wiederum ein drittes Bewegungselement 19 angeordnet, welches als Führung für einen Schlitten ausgebildet ist und sicherstellt, dass das Trägerelement 11 in x-Richtung beweglich ist (zweite Translationsachse). Der vorgenannte Schlitten ist wiederum ein weiteres Bewegungselement, nämlich ein viertes Bewegungselement 20. Das vierte Bewegungselement 20 ist derart ausgebildet, dass das Trägerelement 11 in y-Richtung beweglich ist (dritte Translationsachse). Hierzu weist das vierte Bewegungselement 20 eine Führung auf, in dem ein weiterer Schlitten geführt wird, an dem die Probenaufnahme 14 angeordnet ist.

Die Probenaufnahme 14 wiederum ist mit einem fünften Bewegungselement 21 ausgebildet, welches es ermöglicht, dass die Probenaufnahme 14 um eine zweite Drehachse 22 drehbar ist (zweite Rotationsachse). Die zweite Drehachse 22 ist senkrecht zur ersten Drehachse 17 orientiert.

Aufgrund der oben beschriebenen Anordnung weist das Trägerelement 11 des hier diskutierten Ausführungsbeispiels folgende kinematische Kette auf: erstes Bewegungselement 18 (Bewegung entlang der z-Achse) - zweites Bewegungselement 15 (Drehung um die erste Drehachse 17) - drittes Bewegungselement 19 (Bewegung entlang der x-Achse) - viertes Bewegungselement 20 (Bewegung entlang der y-Achse) - fünftes Bewegungselement 21 (Drehung um die zweite Drehachse 22).

Bei einem weiteren (hier nicht dargestellten) Ausführungsbeispiel ist es vorgesehen, weitere Bewegungselemente vorzusehen, so dass Bewegungen entlang weiterer translatorischer Achsen und/oder um weitere Rotationsachsen ermöglicht werden.

Wie aus der **Figur 3** ersichtlich ist, ist jedes der vorgenannten Bewegungselemente mit einem Schrittmotor verbunden. So ist das erste Bewegungselement 18 mit einem ersten Schrittmotor M1 verbunden und wird aufgrund einer von dem ersten Schrittmotor M1 zur Verfügung gestellten Antriebskraft angetrieben. Das zweite Bewegungselement 15 ist mit einem zweiten Schrittmotor M2 verbunden, welches das zweite Bewegungselement 15 antreibt. Das dritte Bewegungselement 19 ist wiederum mit einem dritten Schrittmotor M3 verbunden. Der dritte Schrittmotor M3 stellt eine Antriebskraft zum Antrieb des dritten Schrittmotors M3 zur Verfügung. Das vierte Bewegungselement 20 ist mit einem vierten Schrittmotor M4 verbunden, wobei der vierte Schrittmotor M4 das vierte Bewegungselement 20 antreibt. Ferner ist das fünfte Bewegungselement 21 mit einem fünften Schrittmotor M5 verbunden. Der fünfte Schrittmotor M5 stellt eine Antriebskraft zur Verfügung, welches das fünfte Bewegungselement 21 antreibt.

Die vorgenannten Schrittmotoren M1 bis M5 werden durch eine Steuereinheit 23 gesteuert (vgl. **Figuren 1** **und** **3**). Die Steuereinheit 23 weist eine Speichereinheit 24 auf, in der ein Computerprogrammprodukt geladen ist, das ein weiter unten erläutertes Verfahren ausführt.

Die Steuereinheit 23 ist mit einer Bedieneinheit (nicht dargestellt) verbunden, welche die Positionen des als Probentisch ausgebildeten Trägerelements 11 steuert. Dabei kann zum Beispiel durch die Bedieneinheit eine neue Position des Trägerelements 11 und damit eine neue Position der Probe eingegeben werden. Nach dem Eingabebefehl fährt dann das Trägerelement 11 unter Verwendung des beschriebenen Verfahrens zur Ansteuerung der Schrittmotoren an die vorgegebene neue Position. Dazu wird aus dem erforderlichen Verschiebeweg bzw. der erforderlichen Winkeländerung des Trägerelements 11 unter Kenntnis der Schrittweite des Antriebs (also derjenigen Verschiebungsstrecke oder desjenigen Kippwinkels, der pro Schritt des betreffenden Schrittmotors (M1 bis M5) erreicht wird) die zum Erreichen der neuen Position erforderliche Anzahl an Schritten für jeden der Schrittmotoren M1 bis M5 errechnet. Anschließend wird bestimmt, innerhalb welcher Schrittzahlen die Beschleunigung des Trägerelements 11 und damit der Anstieg der Amplituden der Motorströme für jeden der Schrittmotoren M1 bis M5 erfolgen soll und innerhalb welcher Schrittzahlen die Abbremsung des Trägerelements 11 und damit die Absenkung der Amplituden der Motorströme für jeden der Schrittmotoren M1 bis M5 auf den jeweiligen Haltestrom erfolgen soll. Nachfolgend wir dann die neue Position angefahren.

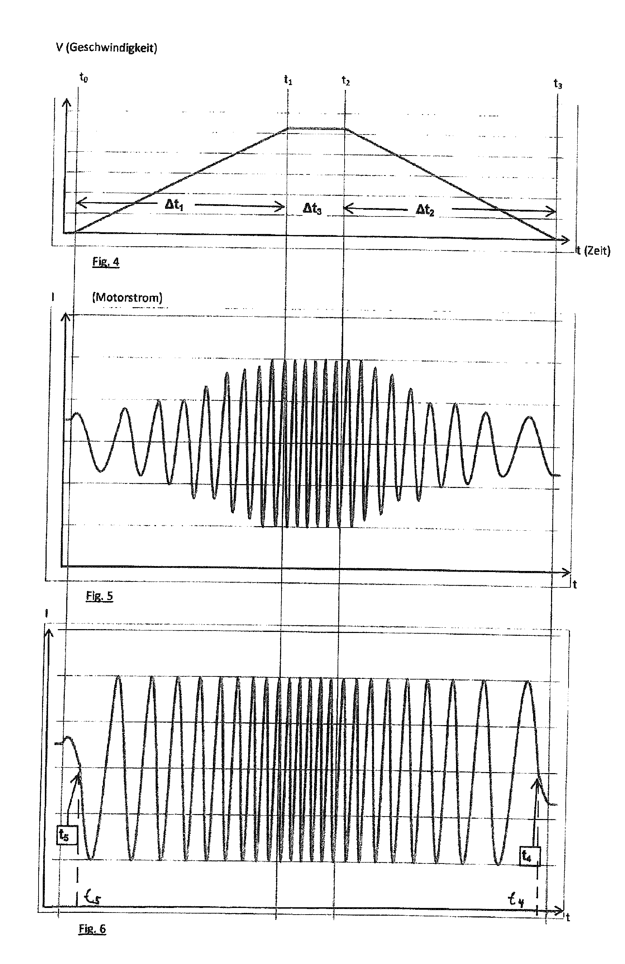

Das Verfahren wird nun beispielhaft anhand einer Ansteuerung des ersten Schrittmotors M1 mittels der **Figuren 4 bis 6** erläutert. Die Ansteuerung der weiteren Schrittmotoren M2 bis M5 erfolgt analog zu der Ansteuerung des ersten Schrittmotors M1.

**Figur 4** zeigt den zeitlichen Verlauf der Geschwindigkeit des Schrittmotors M1 und somit auch des ersten Bewegungselements 18 in einer gewissen Zeit. **Figur 5** zeigt den Verlauf des ersten Motorstroms I, welcher einer Spule des ersten Schrittmotors M1 zugeführt wird, in dieser gewissen Zeit. Der erste Schrittmotor M1 weist mehrere Spulen auf. Der erste Motorstrom I wird diesen Spulen des ersten Schrittmotors M1 phasenversetzt zugeführt.

Zunächst wird zu einem Startzeitpunkt t₀ eine Bewegung des Trägerelements 11 durch Ansteuern des ersten Schrittmotors M1 mit dem als Wechselstrom ausgebildeten ersten Motorstrom I gestartet. Das Starten der Bewegung umfasst ein Beschleunigen des ersten Schrittmotors M1 und somit auch des ersten Bewegungselements 18 während einer Beschleunigungsphase Δt₁. Die Beschleunigungsphase Δt₁ ist ein Zeitraum, der durch die Differenz eines ersten Zeitpunkts t₁ zum Startzeitpunkt t₀ gegeben ist. Zum ersten Zeitpunkt t₁ ist eine Zielgeschwindigkeit V1 erreicht. Der erste Motorstrom I wird nun von der Steuereinheit 23 derart eingestellt, dass dieser zunächst eine erste Beschleunigungs-Frequenz und eine erste Beschleunigungs-Amplitude während der Beschleunigungsphase Δt₁ aufweist. Die erste Beschleunigungs-Frequenz und die erste Beschleunigungs-Amplitude werden während Beschleunigungsphase Δt₁ erhöht, bis zum ersten Zeitpunkt t₁ eine erste Frequenz und eine erste Amplitude des ersten Motorstroms I erzielt sind. Bei dem Ausführungsbeispiel gemäß der **Figur 5** werden die Amplitude und die Frequenz des ersten Motorstroms I während der Beschleunigungsphase Δt₁ kontinuierlich erhöht, bis die erste Frequenz und die erste Amplitude des ersten Motorstroms I erzielt sind. Bei einem weiteren Ausführungsbeispiel, das in der **Figur 6** näher dargestellt ist, ist es alternativ vorgesehen, dass zwar die Frequenz des ersten Motorstroms I während der Beschleunigungsphase Δt₁ kontinuierlich erhöht wird, bis die erste Frequenz erzielt ist. Hingegen wird jedoch die Amplitude des ersten Motorstroms I zu einem Zeitpunkt t₅, welcher sich in der Beschleunigungsphase Δt₁ befindet, sprunghaft auf die erste Amplitude erhöht. Im Grunde handelt es sich um eine sprunghafte Erhöhung der Amplitude des ersten Motorstroms I. Die sprunghafte Erhöhung kann dabei in einem einzelnen Schritt erfolgen oder aber auch in mehreren, stufenweisen Erhöhungen, bis die erste Amplitude erzielt wurde.

Die Geschwindigkeit V des ersten Schrittmotors M1 ist frequenzabhängig. Somit ist die Zielgeschwindigkeit V1 von der ersten Frequenz des ersten Motorstroms I abhängig und durch diese bestimmt. Die Einstellung der ersten Beschleunigungs-Frequenz und der ersten Beschleunigungs-Amplitude des ersten Motorstroms I erfolgt derart, dass die erste Frequenz größer als die erste Beschleunigungs-Frequenz ist und dass die erste Amplitude größer als die erste Beschleunigungs-Amplitude ist.

Während einer Einstellphase Δt₃ werden die erste Frequenz und die erste Amplitude des ersten Motorstroms I konstant gehalten, so dass während der Einstellphase Δt₃ der erste Schrittmotor M1 die Zielgeschwindigkeit V1 aufweist. Die Einstellphase Δt₃ ist durch die Differenz eines zweiten Zeitpunkts t₂ zu dem ersten Zeitpunkt t₁ gegeben.

Zum zweiten Zeitpunkt t₂ beginnt eine Abbremsphase Δt₂, welche durch die Differenz eines dritten Zeitpunkts t₃ zu dem zweiten Zeitpunkt t₂ gegeben ist. Zum dritten Zeitpunkt t₃ bewegt sich der erste Schrittmotor M1 und somit auch das Trägerelement 11 nicht mehr. Während der Abbremsphase Δt₂ erfolgt ein Abbremsen der Bewegung des Trägerelements 11 durch Verringern der ersten Frequenz und durch gleichzeitiges Verringern der ersten Amplitude des ersten Motorstroms I, wobei die erste Frequenz über die gesamte Abbremsphase Δt₂ stetig bis auf Null verringert wird. Im gleichen Zeitraum wird die erste Amplitude des ersten Motorstroms I auf eine Amplitude eines vorgebbaren ersten Haltestroms verringert.

Nach dem Ausführungsbeispiel gemäß der **Figur 5****,** wird im Mikroschrittbetrieb des ersten Schrittmotors M1 über die gesamte Abbremsphase Δt₂, in dem die erste Frequenz des ersten Motorstroms I verringert und auf Null eingestellt wird, auch die erste Amplitude des ersten Motorstroms I verändert. Die Veränderung der ersten Amplitude des ersten Motorstroms I erfolgt bei dem hier dargestellten Ausführungsbeispiel kontinuierlich. Die erste Amplitude wird während der gesamten Abbremsphase Δt₂ derart abgesenkt, bis die Amplitude des Haltestroms erreicht ist. Bei diesem Haltestrom ist der erste Schrittmotor M1 im Stillstand. Die Ansteuerung des ersten Motorstroms I zum Erzielen einer Halteposition erfolgt demnach, noch während der erste Schrittmotor M1 in Bewegung ist, also während der erste Motorstrom I noch eine von Null verschiedene Frequenz aufweist.

Nach dem Ausführungsbeispiel gemäß der **Figur 6** erfolgt die Veränderung der ersten Amplitude des ersten Motorstroms I nicht kontinuierlich, sondern zu einem Zeitpunkt t₄, welcher in der Abbremsphase Δt₂ liegt, wird die Amplitude des ersten Motorstroms I von der ersten Amplitude auf die Amplitude des Haltestroms abgesenkt. Im Grunde handelt es sich um eine sprunghafte Absenkung der Amplitude des ersten Motorstroms I. Die sprunghafte Absenkung kann dabei in einem einzelnen Schritt erfolgen oder aber auch in mehreren, stufenweisen Absenkungen, bis die Amplitude des Haltestroms erzielt wurde. Auch bei dieser Ausführungsform erfolgt die Absenkung der Amplitude des ersten Motorstroms I zu einer Zeit, zu welcher der erste Motorstrom I noch eine von Null verschiedene Frequenz aufweist.

Wie vorstehend beschrieben, wird zunächst ausgehend vom jeweiligen Haltestrom für jeden der Schrittmotoren M1 bis M5 innerhalb der vorbestimmten Schrittzahl für die Beschleunigungsphase die Amplitude und die Frequenz des Motorstroms angehoben, bis die maximale Amplitude und die maximale Frequenz des Motorstroms erreicht wird. Nachfolgend wird dann die vorbestimmte Anzahl an Schritten - abzüglich der zuvor für die Beschleunigung und die Abbremsung vorbestimmten Schrittzahl - für jeden der Schrittmotoren M1 bis M5 ein Motorstrom mit maximaler Amplitude und Frequenz bereitgestellt. Im Anschluss daran wird dann innerhalb der für die Abbremsung des Trägerelements 11 vorbestimmten Schrittzahl die Amplitude und die Frequenz des Motorstroms für jeden der Schrittmotoren M1 bis M5 wieder abgesenkt, bis die Amplitude des Motorstroms wieder den Haltestrom und die Frequenz des Motorstroms die Frequenz Null erreicht, also ein zeitlich konstanter Motorstrom mit der Amplitude des Haltestromes bereitgestellt wird. Für jeden einzelnen Schrittmotor M1 bis M5 wird für jede seiner Wicklungen ein Motorstrom bereitgestellt. Diejenigen Motorströme, die für die verschiedenen Wicklungen desselben Schrittmotors bereitgestellt werden, weisen jeweils dieselbe Amplitude und dieselbe Frequenz, aber zu einander verschiedene Phasentagen auf. Dadurch kann für jeden der Schrittmotoren M1 bis M5 in der Abbremsphase erreicht werden, dass der Schrittmotor in einer Mikroschritt-Position, d.h. in einer Position zwischen zwei Vollschrittes, stehen bleibt. Hat jeder der Schrittmotoren M1 bis M5 zwei Wicklungen, so wird für jede Wicklung ein eigener Motorstrom bereitgestellt, der dieselbe Frequenz aufweist, zwischen denen aber eine Phasenverschiebung besteht.

Hat also der Strom für die erste Wicklung den Strom 11 = A cos ft, beträgt der Strom für die zweite Wicklung 12 = A cos (ft+phi), wobei A die Amplitude des Stroms, f die Frequenz des Stroms, t die Zeit und phi die Phasenverschiebung zwischen den beiden Motorströmen ist. Hat jeder der Schrittmotoren M1 bis M5 mehr als zwei Wicklungen, wird für jede der Wicklungen ein Motorstrom mit derselben Amplitude und derselben Frequenz, aber mit unterschiedlichen Phasenverschiebungen bereitgestellt. In der Beschleunigungsphase und in der Abbremsphase werden die für alle Motorströme für denselben Schrittmotor identische Amplitude A und Frequenz angehoben bzw. in der Abbremsphase abgesenkt. Bei Erreichen der Halteposition beträgt die Amplitude A der Motorströme den Wert des Haltestroms, und der Motorstrom für sämtliche Wicklungen hat die Frequenz Null. In der Haltephase wird dann jede Wicklung eines jeden Schrittmotors mit einem Gleichstrom beaufschlagt, wobei die Stärken der Gleichströme, mit denen die verschiedenen Wicklungen desselben Schrittmotors beaufschlagt werden, dem Cosinus der Phasenverschiebungen zueinander entsprechen.

Das zuvor für den Schrittmotor M1 beschriebene Verfahren kann, wie bereits oben erwähnt, auf alle weiteren Schrittmotoren M2 bis M5 ausgedehnt werden. Es besteht auch die Möglichkeit, dass mehrere Schrittmotoren gleichzeitig das beschriebene Verfahren durchführen. Dies wird insbesondere dann angewendet, wenn die Steuereinheit 23 mit einer Bedieneinheit ausgestattet ist, die eine Bewegung des Trägerelements 11 entlang mehrerer Translationsachsen und auch Rotationsachsen gleichzeitig gestattet. So erlaubt beispielsweise ein Joystick oder eine Rollkugel eine gleichzeitige Bewegung in x- und y-Richtung. Zudem kann die Stärke der Auslenkung des Joysticks oder die Geschwindigkeit der Drehung der Rollkugel die Geschwindigkeit der Schrittmotoren M1 bis M5 steuern. Der Haltestrom wird dabei für jeden Schrittmotor M1 bis M5 so bestimmt, dass das vom Schrittmotor beim Haltestrom erzeugte Drehmoment größer ist als das Losbrechmoment der angetriebenen Mechanik, das für die Überwindung der Haftreibung der Mechanik erforderlich ist. Die Amplitude des Haltestroms sollte gleichzeitig 25% bis 70 %, bevorzugt 40% bis 60%, der Amplitude des Fahrstroms betragen.

Die Amplitude des Haltestroms ist dabei also so groß, dass der Schrittmotor bei dieser Amplitude des Motorstroms aus dem Stand anlaufen kann und nur deshalb im Stillstand gehalten wird, weil die Frequenz des Haltestroms Null ist. Beim Anfahren des Schrittmotors aus dem Stillstand wird mindestens der erste Mikroschritt mit einer Stromamplitude gefahren, die dem Haltestrom entspricht. Es wird also zuerst die Frequenz des Motorstroms angehoben und erst danach dessen Amplitude. Entsprechend umgekehrt wird dann auch der letzte Mikroschritt vor Erreichen der Zielposition wieder mit einem Motorstrom gefahren, dessen Amplitude dem Haltestrom entspricht. Da nach Erreichen der Halteposition die Amplitude des Motorstroms nicht weiter verändert wird, ist sichergestellt, dass der Motor in dieser so eingestellten Stellung stehen bleibt, auch wenn es sich um eine Mikroschrittstellung des Schrittmotors handelt.

Da für das anhand der **Figuren 2** **und** **3** beschriebene Ausführungsbeispiel die Losbrechmomente für die Bewegungen entlang oder um die verschiedenen Bewegungsachsen unterschiedlich sind, können die Amplituden der Halteströme für die verschiedenen Schrittmotoren M1 bis M5 unterschiedlich sein. Bei sämtlichen Schrittmotoren M1 bis M5 erfolgt jedoch die Anhebung der Amplitude des Motorstroms erst, nachdem der Schrittmotor mindestens einen Mikroschritt angelaufen ist, und die Absenkung der Amplitude des Motorstroms auf den Haltestrom erfolgt bereits, bevor der letzte Mikroschritt vor Erreichen der Zielposition durchgeführt wird.

Wird gleichzeitig eine Bewegung entlang bzw. um mehrere Achsen gestartet, so sind bei dem anhand der **Figuren 2** **und** **3** beschriebenen Ausführungsbeispiel grundsätzlich zwei verschiedenen Betriebsmodi möglich, die sogenannte Standardsteuerung und die sogenannte Bahnsteuerung. Bei der Standardsteuerung wird für jeden Schrittmotor M1 bis M5 die maximal mögliche Frequenz und Amplitude des Motorstroms nach der Beschleunigungsphase bereitgestellt. Als Konsequenz laufen alle Antriebe gleichzeitig los. Jeder Antrieb stoppt dann, wenn für die Bewegung um oder entlang der zugehörigen Achse die Zielposition erreicht ist. Im Allgemeinen werden dann die verschiedenen Antriebe zu unterschiedlichen Zeiten ihre Zielpositionen erreichen und stoppen. Bei der Bahnsteuerung laufen zwar ebenfalls alle aktivierten Antriebe gleichzeitig los, allerdings werden die Frequenzen der Motorströme für die verschiedenen Achsen so aufeinander abgestimmt, dass alle aktivierten Antriebe zum gleichen Zeitpunkt ihre jeweilige Zielposition erreichen und stoppen.

Neben der zuvor beschriebenen Angabe der neuen Position besteht auch die Möglichkeit, über die Bedieneinheit eine gewünschte Geschwindigkeit vorzuwählen, mit der das Trägerelement 11 und damit der Probentisch verfahren werden soll. Neben der Steuerung des Probentisches durch Eingabe zum Bespiel der Positionen und der Geschwindigkeiten besteht auch bevorzugt die Möglichkeit, dass die Bedieneinheit mit Joystick, Rollkugel, Taster oder ähnlichen Bedienelementen zur Positionssteuerung ausgestattet ist. Mit Hilfe dieser Bedienelemente kann sowohl der Start und das Ende einer Bewegung als auch die Richtung und die Geschwindigkeit der Bewegung vorgegeben werden. In jedem Fall wird aber zu Beginn einer Bewegungseinleitung, also wenn das Bedienelement aus der Ruheposition in eine Verfahrposition verstellt wird, zunächst die Frequenz und danach auch die Amplitude der jeweils angesteuerten Motorströme angehoben, bis sowohl die Frequenz als auch die Amplitude des Motorstroms den Maximalwert erreichen. Ebenso wird dann, wenn das Bedienelement wieder die Ruhestellung erreicht, sowohl die Frequenz als auch die Amplitude des Motorstroms abgesenkt, bis der Motorstrom wieder die Amplitude des Haltestroms und die Frequenz Null aufweist, der Motorstrom also wieder als Gleichstrom bereitgestellt wird. Auch hier erfolgen der erste Mikroschritt beim Anfahren und der letzte Mikroschritt vor dem Stillstand mit einer Amplitude des jeweiligen Motorstroms, die dem jeweiligen Haltestrom entspricht.

Die Erfindung ermöglicht, dass der jeder der Schrittmotoren M1 bis M5 (und damit auch das Trägerelement 11) an einer gewünschten Position stehen bleibt und kein Bewegen der Schrittmotoren in Richtung des nächsten Vollschrittes mehr erfolgt. Ferner ermöglicht die Erfindung, dass es zu keinen hohen Erwärmungen der Schrittmotoren M1 bis M5 kommt.

### Bezugszeichenliste

| | |
|---|---|
| 1 | Teilchenstrahlsäule eines Teilchenstrahlgeräts |
| 1a | optische Achse |
| 2 | Elektronenquelle |
| 3 | Extraktionselektrode |
| 4 | Anode |
| 5 | Strahlführungsrohr |
| 6 | Objektivlinse |
| 7 | Polschuhe |
| 8 | Spulen |
| 9 | Einzelelektrode |
| 10 | Rohrelektrode |
| 11 | Trägerelement |
| 12 | Rastereinrichtung |
| 13 | Detektor |
| 14 | Probenaufnahme |
| 15 | zweites Bewegungselement |
| 16 | Gehäuse |
| 17 | erste Drehachse |
| 18 | erstes Bewegungselement |
| 19 | drittes Bewegungselement |
| 20 | viertes Bewegungselement |
| 21 | fünftes Bewegungselement |
| 22 | zweite Drehachse |
| 23 | Steuereinheit |
| 24 | Speichereinheit |
| | |
| M1 | erster Schrittmotor |
| M2 | zweiter Schrittmotor |
| M3 | dritter Schrittmotor |
| M4 | vierter Schrittmotor |
| M5 | fünfter Schrittmotor |

## Patentansprüche

1. Verfahren zur Einstellung einer Position eines Trägerelements (11), das in einem Teilchenstrahlgerät (1) angeordnet ist, wobei
- das Trägerelement (11) zur Aufnahme eines Objekts ausgebildet ist,
- das Teilchenstrahlgerät (1) mindestens einen Strahlerzeuger (2) zur Erzeugung eines Teilchenstrahls und mindestens ein Objektiv (6) zur Fokussierung des Teilchenstrahls aufweist, und wobei
- das Trägerelement (11) mittels mindestens eines ersten Schrittmotors (M1 bis M5) beweglich ausgebildet ist,
wobei das Verfahren die folgenden Schritte aufweist:
- Starten einer Bewegung des Trägerelements (11) durch Ansteuern des ersten Schrittmotors (M1 bis M5) mit einem als Wechselstrom ausgebildeten ersten Motorstrom (I),
- Einstellen des ersten Motorstroms (I) auf eine erste Frequenz und auf eine erste Amplitude, und
- Abbremsen der Bewegung des Trägerelements (11) durch Verringern der ersten Frequenz und durch Verringern der ersten Amplitude des ersten Motorstroms (I), wobei die erste Frequenz in einem ersten vorgebbaren Zeitraum (Δt₂) auf Null verringert wird und wobei die erste Amplitude im ersten vorgebbaren Zeitraum (Δt₂) auf eine Amplitude eines vorgebbaren ersten Haltestroms verringert wird.

2. Verfahren nach Anspruch 1, wobei das Verfahren mindestens eines der folgenden Merkmale aufweist:
- das Starten der Bewegung des Trägerelements (11) umfasst ein Beschleunigen während eines zweiten vorgebbaren Zeitraums (Δt₁), und bei dem Verfahren wird der erste Motorstrom (I) mit einer ersten Beschleunigungs-Frequenz und mit einer ersten Beschleunigungs-Amplitude während des zweiten vorgebbaren Zeitraums (Δt₁) angesteuert, wobei die erste Beschleunigungs-Frequenz und die erste Beschleunigungs-Amplitude während des zweiten vorgebbaren Zeitraums (Δt₁) geändert werden, bis die erste Frequenz und die erste Amplitude eingestellt sind, wobei die erste Frequenz größer als die erste Beschleunigungs-Frequenz ist und wobei die erste Amplitude größer als die erste Beschleunigungs-Amplitude ist; oder
- die erste Frequenz und/oder die erste Amplitude werden über einen dritten vorgebbaren Zeitraum (Δt₃) konstant gehalten.

3. Verfahren nach Anspruch 1 oder 2, bei dem eines der folgenden Merkmale gegeben ist:
- das Trägerelement (11) wird entlang mindestens einer ersten Translationsachse (x-Achse) und/oder entlang mindestens einer zweiten Translationsachse (y-Achse) und/oder entlang mindestens einer dritten Translationsachse (z-Achse) bewegt; oder
- das Trägerelement (11) wird entlang mindestens einer ersten Translationsachse (x-Achse) und/oder entlang mindestens einer zweiten Translationsachse (y-Achse) und/oder entlang mindestens einer dritten Translationsachse (z-Achse) bewegt, wobei die erste Translationsachse (x-Achse) und/oder die zweite Translationsachse (y-Achse) und/oder dritte Translationsachse (z-Achse) senkrecht zueinander orientiert sind.

4. Verfahren nach einem der vorangehenden Ansprüche, bei dem eines der folgenden Merkmale gegeben ist:
- das Trägerelement (11) wird um mindestens eine erste Rotationsachse (17) und/oder um mindestens eine zweite Rotationsachse (22) gedreht; oder
- das Trägerelement (11) wird um mindestens eine erste Rotationsachse (17) und/oder um mindestens eine zweite Rotationsachse (22) gedreht, wobei die erste Rotationsachse (17) und die zweite Rotationsachse (22) senkrecht zueinander orientiert sind.

5. Verfahren nach einem der vorangehenden Ansprüche, aber stets in Verbindung mit Anspruch 3, bei dem
- das Trägerelement (11) entlang der ersten Translationsachse (x-Achse) mittels des ersten Schrittmotors (M1 bis M5) bewegt wird, und/oder
- das Trägerelement (11) entlang der zweiten Translationsachse (y-Achse) mittels eines zweiten Schrittmotors (M1 bis M5) bewegt wird, und/oder
- das Trägerelement entlang der dritten Translationsachse (z-Achse) mittels eines dritten Schrittmotors (M1 bis M5) bewegt wird.

6. Verfahren nach Anspruch 5, bei dem das Verfahren die folgenden Schritte aufweist:
- Starten einer Bewegung des Trägerelements (11) durch Ansteuern des zweiten Schrittmotors (M1 bis M5) mit einem als Wechselstrom ausgebildeten zweiten Motorstrom (I),
- Einstellen des zweiten Motorstroms (I) auf eine zweite Frequenz und auf eine zweite Amplitude,
- Abbremsen der Bewegung des Trägerelements (11) durch Verringern der zweiten Frequenz und durch Verringern der zweiten Amplitude des zweiten Motorstroms (I), wobei die zweite Frequenz in einem vierten vorgebbaren Zeitraum (Δt₂) auf Null verringert wird und wobei die zweite Amplitude im vierten vorgebbaren Zeitraum (Δt₂) auf eine Amplitude eines vorgebbaren zweiten Haltestroms verringert wird,
- Starten einer Bewegung des Trägerelements (11) durch Ansteuern des dritten Schrittmotors (M1 bis M5) mit einem als Wechselstrom ausgebildeten dritten Motorstrom (I),
- Einstellen des dritten Motorstroms (I) auf eine dritte Frequenz und auf eine dritte Amplitude, und
- Abbremsen der Bewegung des Trägerelements (11) durch Verringern der dritten Frequenz und durch Verringern der dritten Amplitude des dritten Motorstroms (I), wobei die dritte Frequenz in einem fünften vorgebbaren Zeitraum (Δt₂) auf Null verringert wird und wobei die dritte Amplitude im fünften vorgebbaren Zeitraum (Δt₂) auf eine Amplitude eines vorgebbaren dritten Haltestroms verringert wird.

7. Verfahren nach Anspruch 6, bei dem mindestens eines der folgenden Merkmale gegeben ist:
- das Starten der Bewegung des Trägerelements (11) umfasst ein Beschleunigen während eines sechsten vorgebbaren Zeitraums (Δt₁) umfasst, und bei dem Verfahren wird der zweite Motorstrom (I) mit einer zweiten Beschleunigungs-Frequenz und mit einer zweiten Beschleunigungs-Amplitude während des sechsten vorgebbaren Zeitraums (Δt₁) angesteuert, wobei die zweite Beschleunigungs-Frequenz und die zweite Beschleunigungs-Amplitude während des sechsten vorgebbaren Zeitraums (Δt₁) geändert werden, bis die zweite Frequenz und die zweite Amplitude eingestellt sind, wobei die zweite Frequenz größer als die zweite Beschleunigungs-Frequenz ist und wobei die zweite Amplitude größer als die zweite Beschleunigungs-Amplitude ist; oder
- das Starten der Bewegung des Trägerelements (11) umfasst ein Beschleunigen während eines siebten vorgebbaren Zeitraums (Δt₁), und bei dem Verfahren wird der dritte Motorstrom (I) mit einer dritten Beschleunigungs-Frequenz und mit einer dritten Beschleunigungs-Amplitude während des siebten vorgebbaren Zeitraums (Δt₁) angesteuert, wobei die dritte Beschleunigungs-Frequenz und die dritte Beschleunigungs-Amplitude während des siebten vorgebbaren Zeitraums (Δt₁) geändert werden, bis die dritte Frequenz und die dritte Amplitude eingestellt sind, wobei die dritte Frequenz größer als die dritte Beschleunigungs-Frequenz ist und wobei die dritte Amplitude größer als die dritte Beschleunigungs-Amplitude ist; oder
- die zweite Frequenz und/oder die zweite Amplitude werden über einen elften vorgebbaren Zeitraum (Δt₃) konstant gehalten, und/oder die dritte Frequenz und/oder die dritte Amplitude werden über einen zwölften vorgebbaren Zeitraum (Δt₃) konstant gehalten.

8. Verfahren nach einem der vorangehenden Ansprüche, aber stets in Verbindung mit Anspruch 4, bei dem
- das Trägerelement (11) um die erste Rotationsachse (17) mittels eines vierten Schrittmotors (M1 bis M5) gedreht wird, und/oder bei dem
- das Trägerelement (11) um die zweite Rotationsachse (22) mittels eines fünften Schrittmotors (M1 bis M5) gedreht wird.

9. Verfahren nach Anspruch 8, bei dem das Verfahren die folgenden Schritte aufweist:
- Starten einer Bewegung des Trägerelements (11) durch Ansteuern des vierten Schrittmotors (M1 bis M5) mit einem als Wechselstrom ausgebildeten vierten Motorstrom (I),
- Einstellen des vierten Motorstroms (I) auf eine vierte Frequenz und auf eine vierte Amplitude,
- Abbremsen der Bewegung des Trägerelements (11) durch Verringern der vierten Frequenz und durch Verringern der vierten Amplitude des vierten Motorstroms (I), wobei die vierte Frequenz in einem achten vorgebbaren Zeitraum (Δt₂) auf Null verringert wird und wobei die vierte Amplitude im achten vorgebbaren Zeitraum (Δt₂) auf eine Amplitude eines vorgebbaren vierten Haltestroms verringert wird,
- Starten einer Bewegung des Trägerelements (11) durch Ansteuern des fünften Schrittmotors (M1 bis M5) mit einem als Wechselstrom ausgebildeten fünften Motorstrom (I),
- Einstellen des fünften Motorstroms (I) auf eine fünfte Frequenz und auf eine fünfte Amplitude, und
- Abbremsen der Bewegung des Trägerelements (11) durch Verringern der fünften Frequenz und durch Verringern der fünften Amplitude des fünften Motorstroms, wobei die fünfte Frequenz in einem neunten vorgebbaren Zeitraum (Δt₂) auf Null verringert wird und wobei die fünfte Amplitude im neunten vorgebbaren Zeitraum (Δt₂) auf eine Amplitude eines vorgebbaren fünften Haltestroms verringert wird.

10. Verfahren nach Anspruch 9, bei dem
- die vierte Frequenz und/oder die vierte Amplitude über einen dreizehnten vorgebbaren Zeitraum (Δt₃) konstant gehalten werden, und/oder bei dem
- die fünfte Frequenz und/oder die fünfte Amplitude über einen vierzehnten vorgebbaren Zeitraum (Δt₃) konstant gehalten werden.

11. Verfahren nach Anspruch 9 oder 10, bei dem
- das Starten der Bewegung des Trägerelements (11) ein Beschleunigen während eines zehnten vorgebbaren Zeitraums (Δt₁) umfasst, und bei dem
- der vierte Motorstrom (I) mit einer vierten Beschleunigungs-Frequenz und mit einer vierten Beschleunigungs-Amplitude während des zehnten vorgebbaren Zeitraums (Δt₁) angesteuert wird, wobei die vierte Beschleunigungs-Frequenz und die vierte Beschleunigungs-Amplitude während des zehnten vorgebbaren Zeitraums (Δt₁) geändert werden, bis die vierte Frequenz und die vierte Amplitude eingestellt sind, wobei die vierte Frequenz größer als die vierte Beschleunigungs-Frequenz ist und wobei die vierte Amplitude größer als die vierte Beschleunigungs-Amplitude ist.

12. Verfahren nach einem der Ansprüche 9 bis 11, bei dem
- das Starten der Bewegung des Trägerelements (11) ein Beschleunigen während eines fünfzehnten vorgebbaren Zeitraums (Δt₁) umfasst, und bei dem
- der fünfte Motorstrom (I) mit einer fünften Beschleunigungs-Frequenz und mit einer fünften Beschleunigungs-Amplitude während des fünfzehnten vorgebbaren Zeitraums (Δt₁) angesteuert wird, wobei die fünfte Beschleunigungs-Frequenz und die fünfte Beschleunigungs-Amplitude während des fünfzehnten vorgebbaren Zeitraums (Δt₁) geändert werden, bis die fünfte Frequenz und die fünfte Amplitude eingestellt sind, wobei die fünfte Frequenz größer als die fünfte Beschleunigungs-Frequenz ist und wobei die fünfte Amplitude größer als die fünfte Beschleunigungs-Amplitude ist.

13. Computerprogrammprodukt, das einen Programmcode aufweist, der in einen Steuerungsprozessor (23) eines Teilchenstrahlgeräts (1) ladbar ist und der bei einem Ablauf in dem Steuerungsprozessor (23) das Teilchenstrahlgerät (1) derart steuert, dass ein Verfahren nach einem der vorangehenden Ansprüche durchgeführt wird.

14. Teilchenstrahlgerät (1), mit
- mindestens einem Strahlerzeuger (2) zur Erzeugung eines Teilchenstrahls,
- mindestens einer Objektivlinse (6) zur Fokussierung des Teilchenstrahls auf ein Objekt,
- mindestens einem Detektor (13) zur Detektion von Wechselwirkungsteilchen und/oder Wechselwirkungsstrahlung, die bei Einfall des Teilchenstrahls auf das Objekt erzeugt werden,
- mindestens einem Trägerelement (11) zur Anordnung des Objekts und mindestens einem Schrittmotor (M1 bis M5) zur Bewegung des Trägerelements (11), und mit
- mindestens einem Steuerungsprozessor (23), der ein Computerprogrammprodukt nach Anspruch 13 aufweist.

15. Teilchenstrahlgerät (1), mit
- mindestens einem Strahlerzeuger (2) zur Erzeugung eines Teilchenstrahls,
- mindestens einer Objektivlinse (6) zur Fokussierung des Teilchenstrahls auf ein Objekt,
- mindestens einem Detektor (13) zur Detektion von Wechselwirkungsteilchen und/oder Wechselwirkungsstrahlung, die bei Einfall des Teilchenstrahls auf das Objekt erzeugt werden,
- mindestens einem Trägerelement (11) zur Anordnung des Objekts und mindestens einem Schrittmotor (M1 bis M5) zur Bewegung des Trägerelements (11),
wobei das Teilchenstrahlgerät (1) derart konfiguriert ist, dass
- ein Starten einer Bewegung des Trägerelements (11) durch Ansteuern des ersten Schrittmotors (M1 bis M5) mit einem als Wechselstrom ausgebildeten ersten Motorstrom (I) erfolgt,
- ein Einstellen des ersten Motorstroms (I) auf eine erste Frequenz und auf eine erste Amplitude erfolgt, und dass
- ein Abbremsen der Bewegung des Trägerelements (11) durch Verringern der ersten Frequenz und durch Verringern der ersten Amplitude des ersten Motorstroms (I) erfolgt, wobei die erste Frequenz in einem ersten vorgebbaren Zeitraum (Δt₂) auf Null verringert wird und wobei die erste Amplitude im ersten vorgebbaren Zeitraum (Δt₂) auf eine Amplitude eines vorgebbaren ersten Haltestroms verringert wird.
